# EUROPÄISCHE PATENTANMELDUNG

(11) **EP 3 660 531 A1**
(43) Veröffentlichungstag der Anmeldung: **03.06.2020**
(21) Anmeldenummer: 19216038.0
(22) Anmeldetag: 05.09.2013
(51) Int. Cl.: G01R 35/00, G01R 1/20, G01R 19/00

(54) **VERFAHREN UND SCHALTUNG ZUM PLAUSIBILISIEREN EINES STROMSENSORMESSERGEBNISSES**

(30) Priorität: 07.09.2012 DE 102012215946
(62) Teilanmeldung aus: 13759726.6
(71) Anmelder: Continental Teves AG & Co. OHG, 60488 Frankfurt am Main (DE)
(72) Erfinder: Eckrich, Jörg, 60488 Frankfurt am Main (DE); Jöckel, Wolfgang, 60488 Frankfurt am Main (DE); Rink, Klaus, 60488 Frankfurt am Main (DE); Haverkamp, Martin, 60488 Frankfurt am Main (DE); Martin, Torsten, 60488 Frankfurt am Main (DE); Herchenröder, Jens, 60488 Frankfurt am Main (DE)

(57) **Zusammenfassung**

Es wird ein Verfahren zum Plausibilisieren eines Messergebnisses für einen elektrischen Strom (20) durch einen in einer elektrischen Schaltung (22) verschalteten Stromsensor (2) vorgeschlagen, wobei der Stromsensor (2) wenigstens zwei parallel geschaltete Shunts (36, 38) aufweist, umfassend:
- Durchführen einer vorbestimmten Veränderung (34) am Schaltungszustand der elektrischen Schaltung (22) durch elektrisches Entfernen ein Shunt (38) aus der Schaltung (22);
- Erfassen einer durch die Veränderung (34) des Schaltungszustands hervorgerufene Veränderung (62) des elektrischen Stromes (20) durch den Stromsensor (2) als Messergebnis; und
- Plausibilisieren des Messergebnisses durch Gegenüberstellen der Veränderung (34) des Schaltungszustandes und der Veränderung (62) des elektrischen Stromes (20).

## Beschreibung

Die Erfindung betrifft eine Schaltung zum Leiten eines elektrischen Stromes zwischen einer Fahrzeugbatterie und einer an die Fahrzeugbatterie anschließbaren elektrischen Netzwerkkomponente über ein elektrisches Bauelement sowie ein Fahrzeug mit der Schaltung.

Zur Durchführung von Messungen eines von einer elektrischen Energiequelle an einen elektrischen Verbraucher abgegebenen elektrischen Stromes in einem Kraftfahrzeug können in Reihe zwischen die elektrische Energiequelle und den elektrischen Verbraucher ein Stromsensor geschaltet werden. Ein derartiger Stromsensor ist beispielsweise aus der DE 10 2011 078 548 A1 bekannt.

Es ist Aufgabe der vorliegenden Erfindung bekannte Strommessverfahren zu verbessern.

Die Aufgabe wird durch die Merkmale der unabhängigen Ansprüche gelöst. Bevorzugte Weiterbildungen sind Gegenstand der abhängigen Ansprüche.

Gemäß einem Aspekt der Erfindung umfasst ein Verfahren zum Plausibilisieren eines Messergebnisses eines in einer elektrischen Schaltung verschalteten Stromsensors, wobei der Stromsensor wenigstens zwei parallel geschaltete Shunts aufweist, die folgenden Schritte:
- Durchführen einer vorbestimmten Veränderung am Schaltungszustand der elektrischen Schaltung durch elektrisches Entfernen ein Shunt aus der Schaltung;
- Erfassen einer durch die Veränderung des Schaltungszustands hervorgerufene Veränderung des elektrischen Stromes; und
- Plausibilisieren der Messergebnisse des Stromsensors durch Gegenüberstellen der Veränderung des Schaltungszustandes und der Veränderung des elektrischen Stromes.

Dem angegebenen Verfahren liegt die Überlegung zugrunde, dass Stromsensoren elektrisch in Reihe zwischen die elektrische Energiequelle und den elektrischen Verbraucher geschalten sollten, um die gesamte mit dem elektrischen Strom zu transportierende elektrische Ladung über den Stromsensor zu führen. Basierend auf dieser Überlegung liegt dem angegebenen Verfahren die Erkenntnis zugrunde, dass Defekte in der elektrischen Schaltung, in der der Stromsensor implementiert ist, oder Defekte im Stromsensor selbst, wie beispielsweise parasitäre Kurzschlüsse, dazu führen können, dass ein Teil des elektrischen Stromes und damit der elektrischen Ladung am Stromsensor vorbei geführt wird und durch den Stromsensor nicht erfasst werden kann, was zu einer Fehlmessung mit dem Stromsensor führt. Um eine derartige Fehlmessung zu vermeiden, wird mit dem angegebenen Verfahren vorgeschlagen, die elektrische Schaltung in einen derartigen Zustand zu überführen, in dem der elektrische Strom bekannt ist oder wenigstens aus dem Zustand abgeleitet werden kann. So kann die fehlerfreie Funktion des Stromsensors in der elektrischen sichergestellt werden.

Des Weiteren liegt die Überlegung zugrunde, dass der Stromsensor auch durch die einzelnen parallel geschalteten Shunts, dessen Werte beispielsweise durch die Herstellung bekannt sein müssten, auf seine fehlerfreie Funktionalität hin überwacht werden kann, denn wenn ein Shunt abgeschaltet wird, muss sich der Strom im anderen Shunt in einer dem Fachmann bekannten Weise ändern, was entsprechend verifiziert werden kann.

In einer zusätzlichen Weiterbildung des angegebenen Verfahrens befindet sich die elektrische Schaltung vor dem Zuschalten des elektrischen Verbrauchers in einem wenigstens quasistationären Zustand. Unter einem quasistationären Zustand soll nachstehend ein Zustand verstanden werden, bei dem sich der Zustand der elektrischen Schaltung innerhalb einer vorbestimmten Zeitschranke nur innerhalb eines vorbestimmten Bereichs ändert. In einem stationären Zustand würde sich der Zustand der elektrischen Schaltung überhaupt nicht ändern. Auf diese Weise kann sichergestellt werden, dass sich die vorbestimmte Veränderung am Schaltungszustand nicht mit einer unbekannten Veränderung des Schaltungszustandes überlagert, wodurch sich der elektrische Strom in unbekannter Weise verändern würde und so eine Plausibilisierung der Messergebnisse mit dem Stromsensor unmöglich wäre.

In einer noch anderen Weiterbildung des angegebenen Verfahrens ist die bekannte Stromaufnahme des bekannten elektrischen Verbrauchers von Betriebsbedingungen der elektrischen Schaltung und/oder des elektrischen Verbrauchers abhängig. Dieser Weiterbildung liegt die Überlegung zugrunde, dass der elektrische Widerstand des bekannten elektrischen Verbrauchers den zu messenden elektrischen Strom beeinflusst. Dieser elektrische Widerstand ist jedoch von den Betriebsbedingungen der elektrischen Schaltung mit dem Stromsensor abhängig. Eine Berücksichtigung dieser Betriebsbedingungen im angegebenen Verfahren verbessert daher die Plausibilisierung der Messergebnisse.

In einer bevorzugten Weiterbildung umfassen die Betriebsbedingungen eine am bekannten elektrischen Verbraucher abfallende Betriebsspannung und/oder eine Betriebstemperatur des bekannten elektrischen Verbrauchers und/oder der Schaltung. Dieser Weiterbildung liegt die Überlegung zugrunde, dass nicht alle Betriebsbedingungen in gleicher Weise einen Einfluss auf den elektrischen Widerstand der elektrischen Schaltung haben. Um die Bestimmung der bekannten Stromaufnahme nicht unnötig zu verkomplizieren sollten daher nur die Betriebsbedingungen einen Einfluss auf die bekannten Stromaufnahme haben, die die bekannte Stromaufnahme spürbar verändern, das heißt außerhalb bestimmter vorgebbarer Toleranzwerte.

In einer alternativen Weiterbildung umfasst das angegebene Verfahren die Schritte:
- Durchführen einer zweiten vorbestimmten Veränderung am Schaltungszustand der elektrischen Schaltung;
- Erfassen einer durch die zweite Veränderung des Schaltungszustands hervorgerufene zweite Veränderung des elektrischen Stromes; und
- Gegenüberstellen der Veränderung des Schaltungszustandes und der Veränderung des elektrischen Stromes.

Dieser Weiterbildung des angegebenen Verfahrens liegt die Überlegung zugrunde, dass auch die erste vorbestimmte Veränderung des Schaltungszustandes selbst fehlerhaft sein könnte, weil beispielsweise zur Veränderung des Schaltungszustandes ein defekter Verbraucher an die Schaltung angelegt wird. Dann könnte die Plausibilisierung der Messergebnisse fälschlicherweise entweder positiv oder negativ ausfallen. Um diesen Fall abzufangen wird mit der Weiterbildung des angegebenen Verfahrens vorgeschlagen, die durch die erste vorbestimmte Veränderung des Schaltungszustandes erhaltenen Messergebnisse direkt oder indirekt mit einer weiteren vorbekannten Veränderung des Schaltungszustandes zu plausibilisieren.

Dabei kann die zweite vorbestimmte Veränderung am Schaltungszustand der elektrischen Schaltung gemäß einer besonderen Weiterbildung des angegebenen Verfahrens nach der ersten vorbestimmten Veränderung am Schaltungszustand der elektrischen Schaltung alternativ oder zusätzlich zu dieser durchgeführt.

Gemäß einem weiteren Aspekt der Erfindung ist eine Steuervorrichtung angegeben, die eingerichtet ist, eines der angegebenen Verfahren durchzuführen.

In einer Weiterbildung der Erfindung weist die angegebene Steuervorrichtung einen Speicher und einen Prozessor auf. Dabei ist das angegebene Verfahren in Form eines Computerprogramms in dem Speicher hinterlegt und der Prozessor zur Ausführung des Verfahrens vorgesehen, wenn das Computerprogramm aus dem Speicher in den Prozessor geladen ist.

Die Erfindung betrifft auch ein Computerprogramm mit Programmcodemitteln, um alle Schritte eines der angegebenen Verfahren durchzuführen, wenn das Computerprogramm auf einem Computer oder einer der angegebenen Vorrichtungen ausgeführt wird.

Die Erfindung betrifft auch ein Computerprogrammprodukt, das einen Programmcode enthält, der auf einem computerlesbaren Datenträger gespeichert ist und der, wenn er auf einer Datenverarbeitungseinrichtung ausgeführt wird, eines der angegebenen Verfahren durchführt.

Gemäß einem weiteren Aspekt der Erfindung umfasst eine Fahrzeugbatterie
- einen Batteriepol zum Abgeben eines elektrischen Stromes an einen elektrischen Verbraucher,
- einen an den Batteriepol angeschlossenen Stromsensor zum Erfassen des elektrischen Stromes und
- eine der angegebenen Steuervorrichtung zum Plausibilisieren eines Messergebnisses des Stromsensors, die an den Stromsensor angeschlossen ist.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:
Fig. 1 eine schematische Ansicht eines Stromsensors zwischen zwei Leitungsabschnitten,
Fig. 2 eine schematische Ansicht eines Stromsensors in einer Schaltung,
Fig. 3 eine schematische Ansicht eines alternativen Stromsensors in einer Schaltung,
Fig. 4 eine schematische Ansicht eines Stromsensors in einer alternativen Schaltung, und
Fig. 5 ein Stromverlauf-Diagramm mit Messergebnissen eines Stromsensors zeigen.

In den Figuren werden gleiche technische Elemente mit gleichen Bezugszeichen versehen und nur einmal beschrieben.

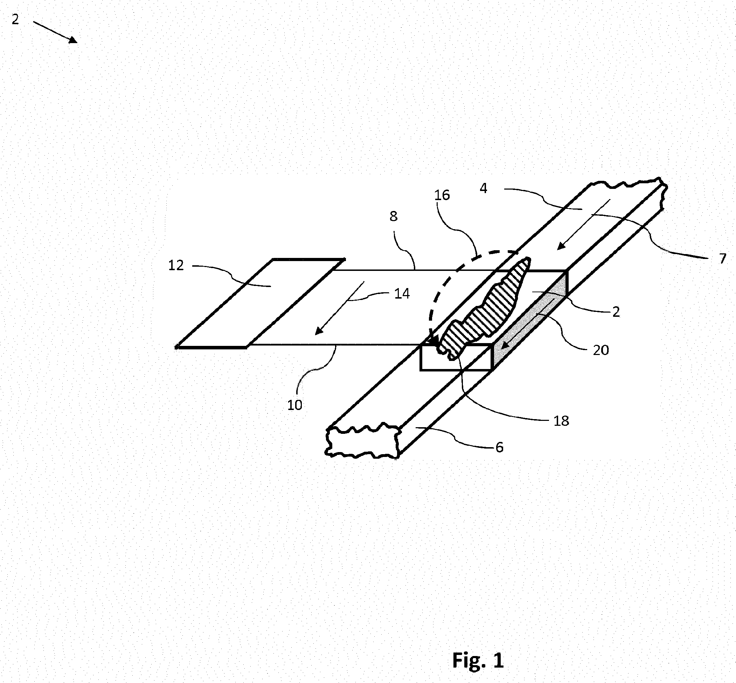

Es wird auf Fig. 1 Bezug genommen, die eine schematische Ansicht eines Stromsensors 2 zwischen zwei Leitungsabschnitten 4, 6 zeigt. Mit dem Stromsensor 2 soll ein elektrischer Strom 7 erfasst werden, der über den Stromsensor 2 durch die beiden Leitungsabschnitte 4, 6 fließt.

Der Stromsensor 2 ist in der vorliegenden Ausbildung als passiver Shunt ausgeführt, der in einer dem Fachmann bekannten Weise ein einfacher elektrischer Widerstand mit einem vorgegebenen Widerstandswert ist. Der Stromsensor 2 kann jedoch auch als aktiver Shunt, wie beispielsweise aus der DE 10 2011 078 548 A1 bekannt, oder basierend auf einem magnetischen Messprinzip aufgebaut sein und ist in seinem Aufbau in keiner Weise beschränkt.

In der vorliegenden Ausführung ist der Stromsensor 2 stoßseitig zwischen den beiden Leitungsabschnitten 4, 6 aufgenommen, wobei an den Verbindungspunkten zwischen den Leitungsabschnitten 4, 6 und dem Stromsensor 2 elektrische Messleitungen 8, 10 elektrisch kontaktiert sind, die zu einer Auswerteschaltung 12 geführt sind. Zwischen den Messleitungen 8, 10 fällt in einer dem Fachmann bekannten Weise eine Messspannung 14 ab. Aus der Messspannung 14 und dem bekannten Widerstandswert des als passiver Shunt ausgebildeten Stromsensors 2 kann in einer dem Fachmann bekannten Weise auf den zu erfassenden Strom 7 geschlossen werden.

Wird der Stromsensor 2 jedoch beispielsweise von einer Verunreinigung 16 überbrückt, so fließt ein Teil des zu erfassenden Stromes 7 nicht über den Stromsensor 2 sondern als parasitärer Strom 18 über diese Verunreinigung 16, wodurch der mit dem Stromsensor 2 erfasste Messstrom 20 um diesen parasitären Strom 18 verfälscht wird. Da sich derartige Verunreinigungen 16 oder andere Defekte am Stromsensor selbst oder an einer den Stromsensor 2 enthaltenden Schaltung erst im Laufe ihres Einsatzes ergeben, sollten diese auch im Laufe ihres Einsatzes erfasst werden. Dazu werden nachstehend Lösungsmöglichkeiten angeboten.

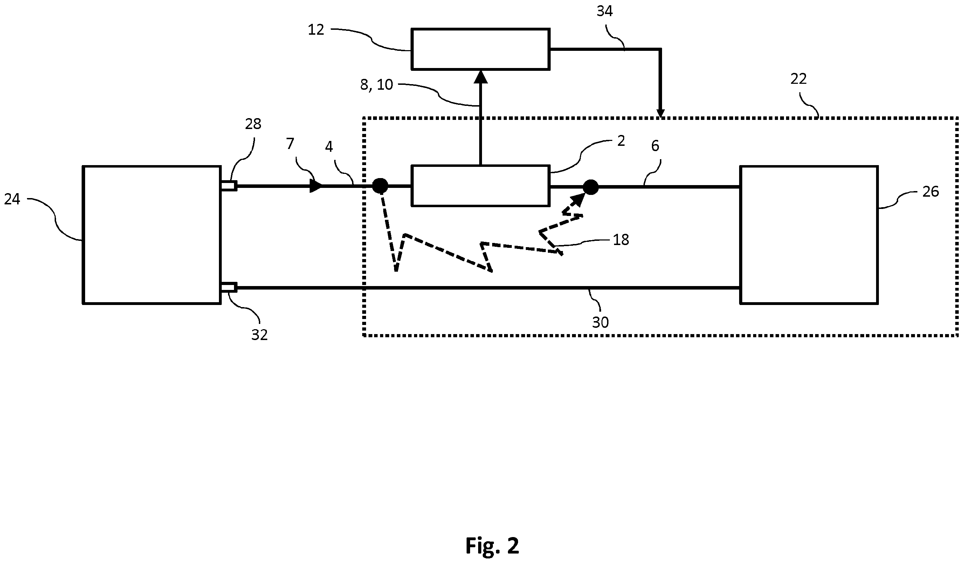

Es wird auf Fig. 2 Bezug genommen, die eine schematische Ansicht des Stromsensors 2 in einer Schaltung 22 zeigt.

In der vorliegenden Ausführung ist der Stromsensor 2 zwischen eine als Batterie ausgeführte elektrische Energiequelle 24 und einen elektrischen Verbraucher 26 geschaltet, wobei der zu erfassende elektrische Strom 7 über einen ersten Batteriepol 28 der Batterie 24 und einen der beiden Leitungsabschnitte 4 an den Stromsensor 2 geleitet wird. Der zu erfassende Strom 7 wird dann über den anderen der beiden Leitungsabschnitte 6 an den elektrischen Verbraucher 26 geleitet und kehrt vom elektrischen Verbraucher über eine Rückleitung 30 und einen zweiten Batteriepol 32 in die Batterie 24 zurück.

Der Stromsensor 2 ist über Messleitungen 8, 10 mit der Auswerteschaltung 12 verbunden, wobei die Messleitungen 8, 10 den Spannungsabfall 14 über dem Stromsensor 2 aber auch weitere zur Messung notwendige Signale, wie beispielsweise ein Regelungssignal übermitteln können, mit dem der Spannungsabfall 14 bei einem aktiven Shunt konstant gehalten werden kann. Zu weiteren Informationen dazu wird auf die DE 10 2011 078 548 A1 verwiesen.

In der vorliegenden Ausführung gibt die Auswerteschaltung 12 ein Zustandsänderungssignal 34 aus, mit dem sie einen Schaltungszustand der Schaltung 22 verändern kann. Der Schaltungszustand kann dabei jede beliebige Einflussgröße sein, die den zu erfassenden elektrischen Strom 7 verändert. Derartige Einflussgrößen können beispielsweise die Verdrahtung der Schaltung 22 oder eine auf die Schaltung 22 einwirkende Temperatur sein, die den zu erfassenden elektrischen Strom 7 verändern.

In der vorliegenden Ausführung wird der Zustand der elektrischen Schaltung 22 mit dem Zustandsänderungssignal 34 so verändert, dass sich der zu erfassende elektrische Strom 7 in einer bekannten Weise verändert. Damit muss sich auch der in Fig. 1 gezeigte, über den Stromsensor 2 fließende Messstrom 20 in der bekannten Weise verändern. Tut er es nicht, fließt ein Teil des zu erfassenden elektrischen Stromes 7 über einen Defekt in der Schaltung 22, wie beispielsweise der Verunreinigung 18 als parasitärer Strom 16, so dass der Messstrom 20 verfälscht ist. Mit der Veränderung des Schaltungszustandes über das Zustandssignal 34 kann die Auswerteschaltung 12 daher den mit dem Stromsensor 2 erfassten Messstrom 20 plausibilisieren.

Nachstehend sollen dazu zwei Beispiele diskutiert werden.

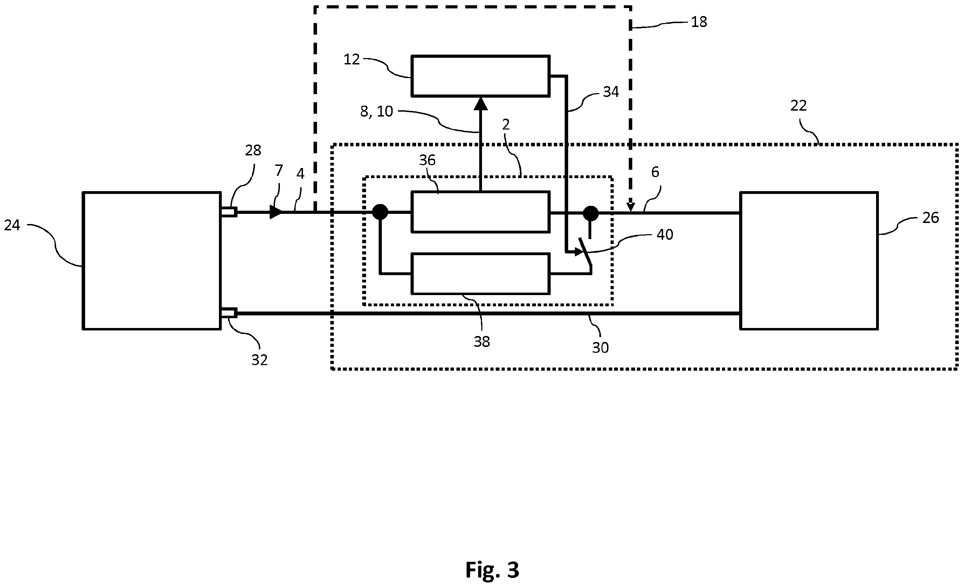

Es wird auf Fig. 3 Bezug genommen, anhand derer ein erstes der beiden Beispiele aufgezeigt werden soll.

In der vorliegenden Ausführung ist der Stromsensor 2 über zwei parallelgeschaltete Einzelshunts 36, 38 aufgebaut, wobei der zweite Einzelshunt 38 über einen durch das Zustandsänderungssignal 34 steuerbaren Schalter 40 aus der Parallelschaltung entfernt werden kann.

Im Einsatz erfasst die Auswerteschaltung den zu erfassenden Strom 7 über den Messstrom 20 zunächst mit beiden Einzelshunts 36, 38 in der gemeinsamen Parallelschaltung und speichert sich den Wert des Messstroms 20 beispielsweise in einem nicht weiter dargestellten internen Speicher. Danach trennt sie den zweiten Einzelshunt 38 aus der Parallelschaltung über das Zustandsänderungssignal 34 und erfasst den Wert des Messstroms 20 erneut.

Im fehlerfreien Fall hängen die beiden erfassten Werte nun in einer dem Fachmann bekannten Weise voneinander ab. Sind die beiden Einzelshunts 36, 38 beispielsweise in ihrem Widerstandswert gleich groß, so müsste sich der Wert des Messstromes 20 nach Abschalten des zweiten Einzelshunts 38 verdoppelt. Tut er das nicht, fließt ein parasitärer Strom 18.

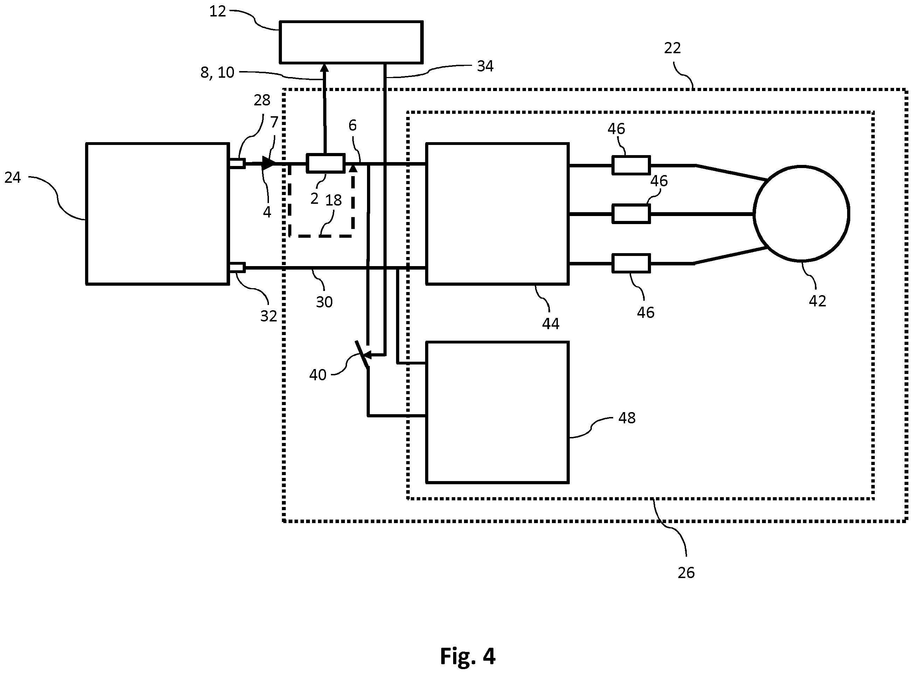

Es wird auf Fig. 4 Bezug genommen, anhand derer das zweite der beiden Beispiele aufgezeigt werden soll.

Im zweiten Beispiel wird nicht der Stromsensor 2, sondern der an den Stromsensor 2 angeschlossene elektrische Verbraucher 26 verändert.

Der elektrische Verbraucher 26 umfasst dazu einen dreiphasigen Elektromotor 42, der über einen Umrichter 44 mit elektrischer Energie aus der Batterie 24 in einer dem Fachmann bekannten Weise versorgt wird. Dabei kann in jeder Phase zusätzlich zum bereits vorhandenen Stromsensor 2 noch ein Einzelphasenstromsensor 46 angeordnet sein, um dem Fachmann bekannte Messaufgaben, wie beispielsweise die Erfassung des magnetischen Ständerfeldes durchzuführen.

Ferner ist in der vorliegenden Ausführung parallel zum Umrichter 44 eine elektrische Heizung 48 geschaltet, die über den mittels des Zustandsänderungssignals 34 schaltbaren Schalter 40 aus der Parallelschaltung getrennt werden kann.

Im Einsatz kann die Auswertevorrichtung 20 die elektrische Heizung 48 zuschalten und messen, um welchen Wert der Messstrom 20 durch den Stromsensor 20 angestiegen ist. Dieser Wert muss zur Stromaufnahme der elektrischen Heizung 48 passen. Tut er es nicht, fließt ein Teil des zu erfassenden Stroms 7 als parasitärer Strom 18.

Die Einzelphasenstromsensoren 46 können dabei ebenfalls mit dem in der vorliegenden Anmeldung vorgestellten Verfahren auf ihre fehlerfreie Funktion hin überprüft werden.

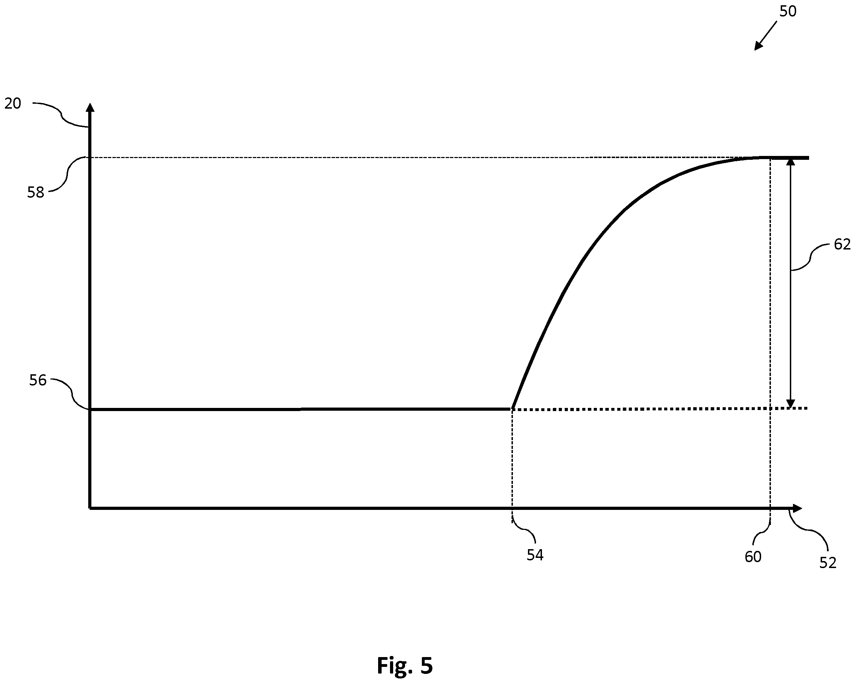

Es wird auf Fig. 5 Bezug genommen, die einen qualitativen Verlauf 50 des Messstromes 18 über die Zeit 52, der mit der in Fig. 4 gezeigten Anordnung aufgenommen ist.

Bevorzugt wird die elektrische Heizung 48 als zusätzlicher elektrischer Verbraucher zu einem Startzeitpunkt 54 eingeschaltet, wenn sich der Messstrom 20 auf einen stationären ersten Wert 56 eingeschwungen hat.

Nach dem Startzeitpunkt 54, wenn die elektrische Heizung 48 parallel zum Umrichter 44 zugeschaltet ist, steigt der Messstrom 20 an und schwingt sich auf einen zweiten stationären Wert 58 ein, der frühestens zu einem Zeitpunkt 60 gemessen werden kann, an dem dieses Einschwingen abgeschlossen ist. Die Zeitdauer zwischen diesen beiden Zeitpunkten liegt in der Regel im Sekundenbereich.

Wenn in einem ordnungsgemäßen Schaltungszustand der Schaltung 22 sollte der Betrag 62 der Differenz zwischen den beiden Werten 58 und 56 des Messstroms 20 der Stromaufnahme der elektrischen Heizung entsprechen.

## Patentansprüche

1. Verfahren zum Plausibilisieren eines Messergebnisses für einen elektrischen Strom (20) durch einen in einer elektrischen Schaltung (22) verschalteten Stromsensor (2), wobei der Stromsensor (2) wenigstens zwei parallel geschaltete Shunts (36, 38) aufweist, umfassend:
- Durchführen einer vorbestimmten Veränderung (34) am Schaltungszustand der elektrischen Schaltung (22) durch elektrisches Entfernen ein Shunt (38) aus der Schaltung (22);
- Erfassen einer durch die Veränderung (34) des Schaltungszustands hervorgerufene Veränderung (62) des elektrischen Stromes (20) durch den Stromsensor (2) als Messergebnis; und
- Plausibilisieren des Messergebnisses durch Gegenüberstellen der Veränderung (34) des Schaltungszustandes und der Veränderung (62) des elektrischen Stromes (20).

2. Verfahren nach einem der vorstehenden Ansprüche, wobei sich die elektrische Schaltung (22) vor dem Zuschalten des elektrischen Verbrauchers (48) in einem wenigstens quasistationären Zustand befindet.

3. Verfahren nach einem der vorstehenden Ansprüche, wobei ein Ergebnis der Gegenüberstellung der Veränderung (34) des Schaltungszustandes und der Veränderung (62) des elektrischen Stromes (20) von Betriebsbedingungen der elektrischen Schaltung (22) und/oder des elektrischen Verbrauchers (48) abhängig ist.

4. Verfahren nach Anspruch 3, wobei die Betriebsbedingungen eine am bekannten elektrischen Verbraucher (48) abfallende Betriebsspannung und/oder eine Betriebstemperatur des bekannten elektrischen Verbrauchers (48) und/oder der Schaltung (22) umfassen.

5. Verfahren nach einem der vorstehenden Ansprüche, umfassend:
- Durchführen einer zweiten vorbestimmten Veränderung (34) am Schaltungszustand der elektrischen Schaltung (22);
- Erfassen einer durch die zweite Veränderung (34) des Schaltungszustands hervorgerufene zweite Veränderung (62) des elektrischen Stromes (20); und
- Gegenüberstellen der Veränderung (34) des Schaltungszustandes und der Veränderung (62) des elektrischen Stromes (20).

6. Verfahren nach Anspruch 5, wobei die zweite vorbestimmte Veränderung (34) am Schaltungszustand der elektrischen Schaltung (22) nach der ersten vorbestimmten Veränderung (34) am Schaltungszustand der elektrischen Schaltung (22) alternativ oder zusätzlich zu dieser durchgeführt wird.

7. Steuervorrichtung (12), die eingerichtet ist, ein Verfahren nach einem der vorstehenden Ansprüche durchzuführen.

8. Fahrzeugbatterie (24) umfassend
- einen Batteriepol (28) zum Abgeben eines elektrischen Stromes (7) an einen elektrischen Verbraucher (26),
- einen an den Batteriepol (28) angeschlossenen Stromsensor (2) zum Erfassen des elektrischen Stromes (7) und
- eine an den Stromsensor (2) angeschlossene Steuervorrichtung (12) nach Anspruch 9 zum Plausibilisieren eines Messergebnisses (20) des Stromsensors (2).
